# EUROPÄISCHE PATENTANMELDUNG

(11) **EP 0 986 289 A2**
(43) Veröffentlichungstag der Anmeldung: **15.03.2000**
(21) Anmeldenummer: 99117661.1
(22) Anmeldetag: 07.09.1999
(51) Int. Cl.: H05K 1/02

(54) **Schaltungsanordnung und Verfahren zur Kennzeichnung von Leiterplatten**

(30) Priorität: 09.09.1998 DE 19841268
(71) Anmelder: SIEMENS AKTIENGESELLSCHAFT, 80333 München (DE)
(72) Erfinder: Musil, Gerhard, 81479 München (DE)

(57) **Zusammenfassung**

Zur Kennzeichnung von Leiterplatten werden auf der Leiterplatte bereits vorhandene und/oder zusätzliche Prüfpunkte zur Kennzeichnung der Leiterplatte verwendet. Entsprechend der vorgesehen Kennzeichnung werden die einzelnen Prüfpunkte mit definierten Potentialen versehen die durch eine Prüfeinheit ausgewertet werden.

## Beschreibung

Baugruppen, insbesondere Flachbaugruppen, die auf Leiterplatten angeordnet sind, müssen für eine Fertigung, eine Qualitätskontrolle oder für Servicezwecke eindeutig bestimmbar sein.

Bisher ist es üblich, daß Leiterplatten durch eine in die Leiterplatte geätzte Typenbeschriftung bezeichnet wurden. Diese Typenbeschriftung wird durch aufgeklebte, gedruckte und manuell beschriftete Schriftfelder ergänzt. Gebräuchlich sind auch Strichcode oder eine Speichereinheit zur Abspeicherung von Baugruppenbezeichnungen, die auf der Leiterplatte angeordnet sind.

Diese Kennzeichnung von auf Leiterplatten angeordneten Baugruppen bringt jedoch den Nachteil mit sich, daß Schriftfelder verändert, Strichcode beschädigt und überklebt werden können. Die Abspeicherung der Leiterplattenkennzeichnung in Speichereinheiten bringt den Nachteil mit sich, daß bei einem betriebsbedingten Austausch des Mikroprozessors oder der Speichereinheit der Speicher neu beschrieben werden muß und so Fehler bei der Kennung der Leiterplatte entstehen können.

Um eine Kennzeichnung von der Leiterplatten durchzuführen sind zudem eigene kostenaufwendige Verfahren zum Lesen und Schreiben der auf der Leiterplatten gespeicherten Kennzeichnung notwendig.

Der Erfindung liegt die Aufgabe zugrunde, eine Schaltungsanordnung und ein Verfahren anzugeben, bei dem die oben genannten Nachteile überwunden werden.

Gemäß der Erfindung wird die gestellte Aufgabe durch die Patentansprüche 1 und 7 gelöst.

Die Erfindung bringt den Vorteil mit sich, daß eine bestehende Struktur zur Prüfung und/oder Messung von Baugruppen auf Leiterplatten zur Kennzeichnung dieser mitverwendet wird.

Die Erfindung bringt den Vorteil mit sich, daß die Kennzeichnung der auf einer Leiterplatte angeordneten Baugruppe oder Baugruppen unverwechselbar auf einfachste Weise mit dieser oder diesen verbunden ist.

Die Erfindung bringt den Vorteil mit sich, daß Manipulationen ausgeschlossen sind und sofort erkannt werden.

Die Erfindung bringt den weiteren Vorteil mit sich, daß eine fortlaufende Nummerierung der Leiterplatten erfolgen kann und eine baugruppenspezifische Kennzeichnung nicht notwendig wird.

Weitere vorteilhafte Ausbildungen der Schaltungsanordnung und des Verfahrens sind in den weiteren Patentansprüchen angegeben.

Weitere Besonderheiten der Erfindung werden aus den nachfolgenden näheren Erläuterungen eines Ausführungsbeispiels anhand von Zeichnung ersichtlich.

Es zeigen:
- Figur 1: eine Kennzeichnung von Leiterplatten,
- Figur 2: eine Variante zur Kennzeichnung von Leiterplatten,
- Figur 3: eine Variante zur Kennzeichnung von Leiterplatten und
- Figur 4: eine weitere Variante zur Kennzeichnung von Leiterplatten.

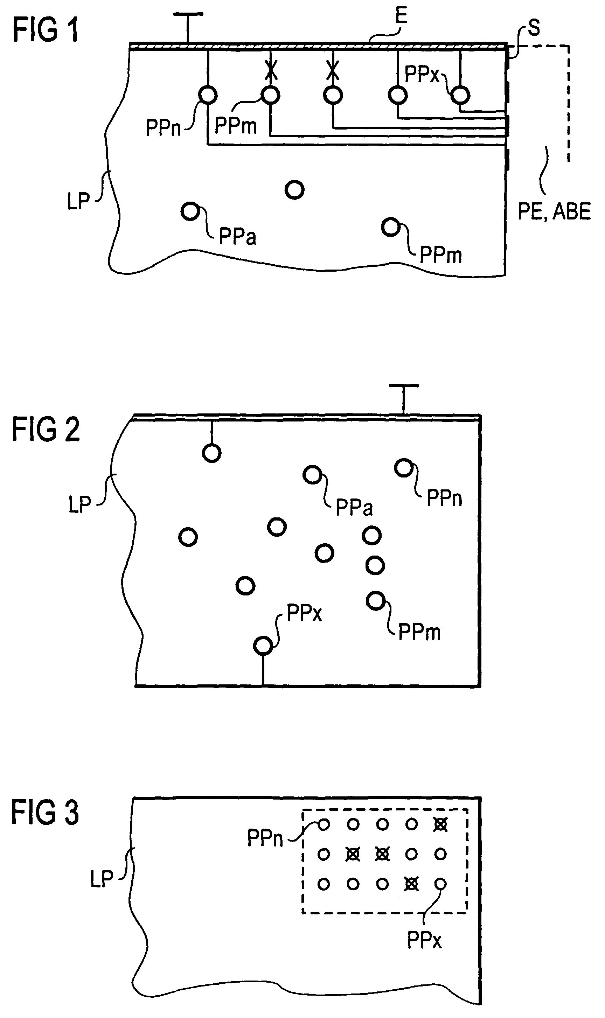

Figur 1 zeigt einen Ausschnitt einer Leiterplatte LP in dem Prüfpunkte PPa bis PPx angeordnet sind. Die Prüfpunkte PPn, .., PPx haben zum einem eine Verbindung zu einer Erdungsschiene E sowie zu einer Steckerleiste S. In dieser Ausführungsvariante sind beispielsweise in einem freien, nicht durch Bauelemente belegten Leiterplattenbereich Prüfpunkte angeordnet, die entweder direkt oder über einen an die Steckerleiste anschließbaren Prüfstecker durch eine Prüfeinheit PE abgefragt werden können. In der Prüfeinheit können die gelesenen Zahlenfolgen auf einen Display angezeigt werden. Der Zahlenfolge kann in einem weiteren Verarbeitungsschritt eine baugruppenspezifische Bezeichnung zugewiesen werden. Nach oder während der Fertigung können die Verbindungen zur Erdungsschiene E unterbrochen werden. Durch die Prüf- oder Abfrageeinheit PE, ABE werden dann die Potentiale an den Prüfpunkten abgefragt und beispielsweise in eine Kennzeichnung oder Zahlenfolge umgesetzt. Hier wird in vorteilhafter Weise eine Prüfeinheit zur Kennzeichnung von Leiterplatten mitbenutzt.

In Figur 2 ist ein Teil einer Leiterplatte LP gezeigt dessen Baugruppen durch eine Vielzahl von Prüfpunkten PPa, .., PPm geprüft werden können. Eine Kennzeichnung der Leiterplatte erfolgt in der Art, daß bei Vorhandensein von freien Prüfpins einer Prüf- oder Abfrageeinheit PE, ABE zusätzliche Prüfpunkte PPn, .., PPx auf er Leiterplatte LP angeordnet werden. Diese Prüfpunkte PPn, .., PPx erhalten entsprechend einer Abfragereihenfolge und einer zu speichernden Zahlenfolge eine Verbindung zu einem Betriebspotential. Je nach Lesereihenfolge der zusätzlichen Prüfpins kann damit eine die auf der Leiterplatte angeordnete Baugruppe eindeutig bestimmt werden.

In Figur 3 ist eine weitere Ausführungsvariante einer Leiterplattenkennzeichnung dargestellt. Hier erfolgt die Kennzeichnung der Leiterplatte LP in einem Prüffeld PPn, .., PPx. Die einzelnen Prüfpunkte PPn, .., PPx haben hier zu unterhalb der Prüfpunkte liegenden Leiterbahnen, an denen ein Betriebspotential anliegt, eine Verbindung. Diese Verbindung zu dem Betriebspotential kann durch ein Ausbohren oder Auftragen einer Lackschicht auf den Prüfpunkt verhindert werden.

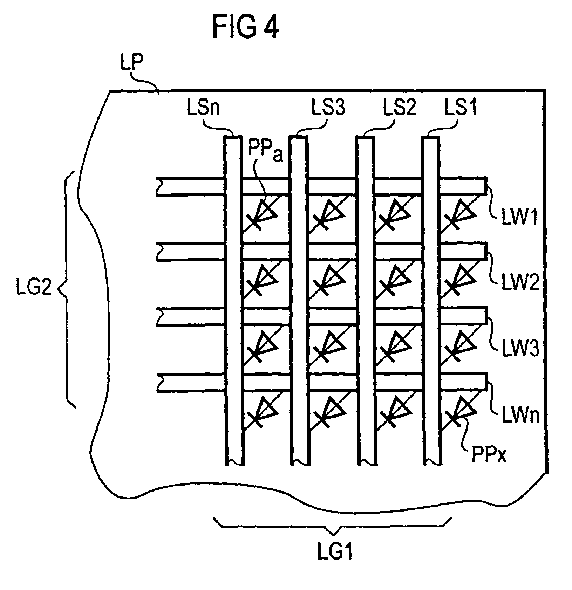

In Figur 4 ist eine weitere Leiterplattenkennzeichnung gezeigt. Bei dieser Ausgestaltung hat die Leiterplatte LP eine erste und zweite Leiterbahngruppe LG1, LG2, die durch Verbindungselemente verbunden sind.

Bei dem gezeigten Ausschnitt der Leiterplatte LP sind die erste Leiterbahngruppe LG1 in einer ersten Schicht der Leiterplatte und die zweite Leiterbahngruppe LG2 in einer zweiten Schicht der Leiterplatte angeordnet.

Die verbindenden Elemente bei einer nx1 oder 1xn Matrix können weitere Leiterbahnen oder bei einer nxm Matrix aktive oder passive Bauelemente sein.

Diese in vorteilhafter Weise in einer ersten und zweiten Ebene angeordneten Leiterbahngruppen LG1, LG2 werden in einem dafür vorgesehen Bereich der Leiterplatte zur Kennzeichnung der Leiterplatte angeordnet. Die Verbindung zwischen den Leiterbahnen der verschiedenen Ebenen kann dauerhaft geöffnet oder über Dioden verbunden werden. Vorteilhaft ist die Ausgestaltung einer Bestimmung der Leiterbahnen in eine z.B. erste Ebene zu Leseleitungen und zweite Ebene zu Schreibleitungen und das Fortführen dieser zu einer Steckerleiste und/oder einem Prüfstecker der Leiterplatte. Wenn sich auf der Baugruppe ein Prozessor befindet oder eine durch diesen unterstützte Lesevorrichtung wie z.B. ein Parallelport oder ein Adressenanschluß an einem Random Access Memory, ist es auch sinnvoll, die ersten oder zweiten Leiterbahngruppen LG1, LG2, die auch als Lese- oder Schreibleitungen bezeichnet werden, dorthin zu führen.

Die auf einer Leiterplatte angeordnete Baugruppe kann durch eine einmalige Codierung nach der Fertigung bezeichnet werden. Die Codierung kann auch während der Fertigung durch Aufbohren oder Wegstanzen der zwischen den Leiterbahngruppen LG1, LG2 angeordneten Verbindungselemente erfolgen. Eine Unterbrechung kann durch ein Zerstören der Halbleiter oder ein Durchschmelzen der Lötverbindung zwischen den Leiterbahngruppen LG1, LG2 erreicht werden.

Eine Codierung der Leiterplatte während der Fertigung ist beispielsweise durch Abdeckung von Verbindungslöchern vor einer Galvanisierung möglich. Ebenso ist ein gezieltes Weglassen von Abdeckungen über den Verbindungsleitungen vor einem Ätzvorgang bei der Herstellung der Leiterplatten möglich.

Werden Verbindungen zwischen den Leiterbahnen LG1, LG2 nach der Fertigung der Leiterplatte eingefügt, so kann dies bei einer 1xn Matrix beispielsweise durch Widerstände, Schalter, Nieten- oder Lötverbindungen geschehen.

Ein Auslesen der Baugruppennummer kann über Leseleitungen in bekannter Weise über die Steckerleisten, Prüfstecker oder über Kontaktierflächen erfolgen.

Oft werden multifunktionale Prozessoren zur Erfüllung einfacher Aufgaben in Schaltungen eingesetzt. Freie Pins können dann zu Zwecken der Kennzeichnung verwendet werden. An die freien Pins herangeführten Leiterbahnen können entsprechend der an ihnen anliegenden Potentiale eine komplette Kennzeichnung oder Teile einer Kennzeichnung für die Baugruppe oder Leiterplatte sein. Diese Art der Kennzeichnung bringt den Vorteil mit, daß bereits nach der Herstellung der Leiterplatte die Kennzeichnung über Prüffelder ausgelesen werden kann, während später die Kennzeichnung oder zumindest wichtige Teile davon über den Prozessor gelesen werden können. Damit kann in einfacher Weise auch dessen Verhalten entsprechend an Baugruppenserien angepaßt werden, falls dies notwendig ist.

Bei einem Lesevorgang werden die zu einer Spalte gehörenden Zeilen einzeln abgefragt. Die Leseleitungen können mit jedem Verfahren gelesen werden, das imstande ist, Verbindungen von Nicht-Verbindungen zu unterscheiden. Eine Verbindung zwischen der ersten und zweiten Leiterbahn LG1, LG2 sind dabei immer einer der Werte 0 oder 1, Nicht-Verbindungen, z.B. hochohmige Verbindungen ist der jeweils andere Binärwert zugeteilt.

Die gesamte Baugruppennummer in Binärdarstellung ergibt sich dann durch eine vorher festgelegte, aber grundsätzlich freie Reihenfolge von 0 und 1 innerhalb der Matrix . Geschieht das über einen Mikroprozessor, so legt dieser über ein Port oder eine Reihe von Ports ein Potential an die Leitungen LW1, LW2,.. LWn der ersten Leiterbahngruppe LG1 und prüft die Potentiale der Leitungen LS1, LS2,..,LSn der zweiten Leiterbahngruppe LG2. Dazu kann es vorteilhaft sein, wenn die Leitungen der zweiten Leiterbahngruppe LG2 hochohmig mit Masse oder einer anderen Baugruppenspannung verbunden sind.

Soll verhindert werden, daß die Baugruppennummer ganz oder teilweise später verändert wird, so können praktisch alle der oben genannten Anordnungen durch Aufbringen von Lackabdeckungen versiegelt werden.

Die Kennzeichenvergabe einer Leiterplatte bzw. Baugruppe kann nach einem international festgelegten Schema, wie etwa eine ISBN Nummer bei Büchern oder bekannten Warenkennzeichnungen vergeben werden. Mit einer Kennzeichenvergabe wird eine Differenzierung bis zur kleinsten Baugruppe bei Anordnungen auf einer Leiterplatte möglich. Mit einer nxm Matrix ergeben sich 2^{n+m} Verbindungspunkte. Bei einer 6 * 6 Matrix, d.h. mit 12 Leitungen und den dazugehörigen Verbindungselementen können 68,7 Milliarden Werte für eine Kennung von Leiterplatten oder auf Leiterplatten angeordneten Baugruppen vergeben werden.

## Patentansprüche

1. Schaltungsanordnung zur Kennzeichnung von Leiterplatten (LP) mit einer Mehrzahl von Prüfpunkten (PPa, .., PPx),
**dadurch gekennzeichnet,**
daß ein Teil der Prüfpunkte (PPn, .., PPx) zu einer Kennzeichnung der Leiterplatte vorgesehen ist, wobei die Prüfpunkte (PPn, .., PPx) von einer Prüf- oder Abfrageeinheit (PE, ABE) abgefragt werden und die Kennzeichnung ermittelt wird.

2. Schaltungsanordnung nach Anspruch 1,
**dadurch gekennzeichnet,**
daß zusätzliche Prüfpunkte (PPn, .., PPx) zur Kennzeichnung der Leiterplatte vorgesehen sind, wobei die maximale Anzahl der zusätzlichen Prüfpunkte (PPn, .., PPx) von noch unbelegten Prüfanschlüssen einer Prüf- oder Abfrageeinheit (PE, ABE) vorgegeben wird.

3. Schaltungsanordnung nach den Ansprüchen 1 oder 2,
**dadurch gekennzeichnet,**
daß einzelne der zur Kennzeichnung der Leiterplatte vorgesehene Prüfpunkte mit einem Betriebspotential verbunden sind.

4. Schaltungsanordnung nach einem der vorhergehenden Ansprüche,
**dadurch gekennzeichnet,**
daß die zur Kennzeichnung vorgesehenen Prüfpunkte (PPx) über Leiterbahnverbindungen mit Pins eines Prozessors verbunden sind.

5. Schaltungsanordnung nach einem der vorhergehenden Ansprüche,
**dadurch gekennzeichnet,**
daß Verbindungen von Leiterbahnen (LSn, LWn) in unterschiedlichen Ebenen der Leiterplatte (LG1, LG2) Prüfpunkte bilden.

6. Schaltungsanordnung nach Anspruch 4,
**dadurch gekennzeichnet,**
daß die Verbindungen zwischen den Leiterbahnen (LSn, LWn) bei einer matrixförmigen Anordnung der Leiterbahnen Dioden sind.

7. Verfahren zur Kennzeichnung von Leiterplatten (LP) mit einer Mehrzahl von Prüfpunkten (PPa, .., PPx),
**dadurch gekennzeichnet,**
daß ein Teil der Prüfpunkte (PPn, .., PPx) zu einer Kennzeichnung der Leiterplatte vorgesehen wird, wobei die Prüfpunkte (PPn, .., PPx) von einer Prüf- oder Abfrageeinheit (PE, ABE) abgefragt werden und die Kennzeichnung ermittelt wird.

8. Verfahren nach Anspruch 7,
**dadurch gekennzeichnet,**
daß zusätzliche Prüfpunkte (PPn, .., PPx) zur Kennzeichnung der Leiterplatte vorgesehen werden, wobei die maximale Anzahl der zusätzlichen Prüfpunkte (PPn, .., PPx) von noch unbelegten Prüfanschlüssen einer Prüf- oder Abfrageeinheit (PE, ABE) vorgegeben wird.
